(19) Europäisches Patentamt
European Patent Office
Office européen des brevets

(11) **EP 4 414 880 A1**

(12) **DEMANDE DE BREVET EUROPEEN**

(43) Date de publication:
**14.08.2024 Bulletin 2024/33**

(21) Numéro de dépôt: **24155208.2**

(22) Date de dépôt: **01.02.2024**

(51) Classification Internationale des Brevets (IPC):
**G06F 30/15** (2020.01) **G01C 21/26** (2006.01)
**G06Q 10/047** (2023.01) **G01C 21/34** (2006.01)

(52) Classification Coopérative des Brevets (CPC):
**G06F 30/15; G01C 21/3469; G06Q 10/047**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: **09.02.2023 FR 2301213**

(71) Demandeur: **IFP Energies nouvelles**
**92500 Rueil-Malmaison (FR)**

(72) Inventeurs:
• **DE NUNZIO, Giovanni**
**92852 RUEIL-MALMAISON CEDEX (FR)**
• **SCIARRETTA, Antonio**
**92852 RUEIL-MALMAISON CEDEX (FR)**
• **BEN GHARBIA, Ibtihel**
**92852 RUEIL-MALMAISON CEDEX (FR)**

(74) Mandataire: **IFP Energies nouvelles**
**Département Propriété Industrielle**
**Rond Point de l'échangeur de Solaize**
**BP3**
**69360 Solaize (FR)**

(54) **METHODE DE DIMENSIONNEMENT D'UNE BATTERIE POUR VEHICULE ELECTRIQUE**

(57) L'invention concerne une méthode de dimensionnement et de construction d'une batterie de véhicule électrique mise en oeuvre par ordinateur, la méthode de dimensionnement comprenant au moins les étapes suivantes :

a) on définit plusieurs capacités potentielles (Capo) de la batterie;

b) pour chaque capacité potentielle de la batterie, on utilise un planificateur d'itinéraires (Plan) pour déterminer au moins un itinéraire possible dudit trajet, chaque itinéraire possible étant défini par une succession de portions de route, et on détermine le temps de parcours et/ou la consommation d'énergie ainsi que la position des stations de recharge à utiliser par le véhicule électrique sur chaque itinéraire possible pour recharger sa batterie et le niveau de recharge associé.

c) à partir de ces données pour chaque capacité potentielle de batterie, on identifie la capacité (Dim) de la batterie parmi lesdites capacités potentielles.

**[Fig 1]**

## Description

### Domaine technique

L'invention concerne une méthode de dimensionnement d'une batterie pour véhicule électrique.

Il concerne également une méthode de construction de véhicule électrique où la batterie dimensionnée selon la méthode de dimensionnement est implantée dans le véhicule électrique.

L'invention concerne aussi un produit programme d'ordinateur.

Des études récentes montrent qu'un petit véhicule électrique avec une autonomie d'environ 160 km pourrait répondre aux besoins énergétiques d'environ 90% des jours de conduite, dans différentes villes des États-Unis. De plus, les besoins de la plupart des foyers possédant une seule voiture seraient satisfaits tout en ne nécessitant aucune modification comportementale de plus de 5 % des jours. Cependant, l'inquiétude liée à l'autonomie de conduite est sans doute inévitable pour l'utilisateur. Afin de surmonter ce problème et d'éviter de ralentir les ventes et la diffusion des véhicules électriques, les planificateurs d'itinéraires se répandent de nos jours rapidement.

Si l'optimisation d'itinéraire et de stratégie de recharge représentent des fonctionnalités importantes pour les utilisateurs de véhicules électriques, il existe d'autres leviers pour aider les utilisateurs à passer à l'électromobilité et à les guider dans le choix du véhicule électrique le plus adapté à leurs besoins. En particulier, le choix du véhicule est souvent conditionné à la taille de la batterie qui est souvent choisie pour quelques rares trajets de longue distance. En d'autres termes, les utilisateurs souhaitent que la batterie du véhicule soit suffisamment grande pour permettre le trajet complet (du domicile au lieu de vacances par exemple) avec le nombre de recharges minimum. Cela pousse à acheter des véhicules avec de grandes batteries qui ne sont guère adaptés à un usage quotidien et qui présentent des émissions de $CO_2$ équivalent (en considérant tout le cycle de vie du véhicule) comparables aux véhicules conventionnels à moteur à combustion interne. En effet, le surdimensionnement de la batterie en vue de quelques trajets de longue distance a un impact environnemental important.

### Technique antérieure

La demande de brevet FR3092181 A1 concerne une méthode de dimensionnement de la batterie d'un véhicule électrique. Cependant, cette méthode est basée sur les organes consommateurs et sur la consommation énergétique du véhicule mais les besoins énergétiques de longue distance ne sont pas pris en compte.

L'invention a pour but de vérifier les possibilités des véhicules, c'est-à-dire leurs besoins, en fonction de la taille des batteries (de leur capacité en somme), en termes de temps de trajet, consommation énergétique et de coût financier et environnemental, afin de choisir (dimensionner) la batterie optimale en évitant le surdimensionnement de la batterie.

### Résumé de l'invention

L'objet de l'invention consiste à proposer une méthode de dimensionnement de la batterie en tenant compte de trajets, notamment de trajets longue distance, pour optimiser le temps de trajet et/ou la consommation d'énergie, tout en évitant le surdimensionnement de la batterie. Pour ce faire, l'invention concerne une méthode de dimensionnement d'une batterie d'un véhicule électrique pour implémenter la batterie dans ledit véhicule électrique, à partir de caractéristiques physiques dudit véhicule électrique, d'au moins un trajet d'une origine vers une destination dans un espace prédéterminé, des localisations de stations de recharge dans l'espace prédéterminé, de la puissance de chacune desdites stations de recharge, et d'un planificateur d'itinéraire, l'espace prédéterminé comprenant un réseau routier comprenant des portions de route reliées entre elles par des intersections, la méthode de dimensionnement comprenant au moins les étapes suivantes :

a) on définit plusieurs capacités potentielles de la batterie, lesdites capacités potentielles étant comprises entre une première valeur et une deuxième valeur ;

b) pour chaque capacité potentielle de la batterie, on utilise le planificateur d'itinéraires pour déterminer au moins un itinéraire possible dudit trajet, chaque itinéraire possible étant défini par une succession de portions de route, et on détermine le temps de parcours pour parcourir l'itinéraire possible par ledit véhicule électrique et/ou la consommation d'énergie par ledit véhicule électrique de chaque itinéraire possible ainsi que la position des stations de recharge à utiliser par le véhicule électrique sur chaque itinéraire possible pour recharger sa batterie et le niveau de recharge associé,

c) à partir des temps de parcours et consommation d'énergie déterminées pour chaque capacité potentielle de batterie et de la taille de chaque capacité potentielle de batterie, on identifie la capacité de la batterie parmi lesdites capacités potentielles ; et dans laquelle au moins l'étape b) est mise en oeuvre par ordinateur, et de préférence, toutes les étapes sont mises en oeuvre par ordinateur.

De préférence, le planificateur d'itinéraires réalise au moins les étapes suivantes :

- on construit un graphe de routage à partir du réseau routier, les sommets du graphe de routage représentant les intersections de chaque portion de route et les arcs du graphe de routage représentant les portions de route,
- on positionne les stations de recharge sur le graphe de routage,
- on étend le graphe de routage en multipliant au moins certains arcs en fonction de paramètres prédéfinis, les paramètres prédéfinis comprenant la vitesse de circulation sur la portion de route considérée et/ou le niveau de recharge lors de l'arrêt à une station de recharge,
- on détermine un modèle de consommation énergétique, le modèle énergétique définissant la consommation d'énergie du véhicule électrique en fonction de paramètres prédéterminés en prenant en compte les recharges éventuelles de la batterie du véhicule électrique,
- pour chaque trajet, on applique le modèle de consommation énergétique sur les différents arcs du graphe routage étendu et on définit comme itinéraire final du trajet possible, l'ensemble des arcs permettant de minimiser, par un algorithme d'optimisation tel qu'un algorithme du plus court chemin de Bellman-Ford, le temps de parcours, ou la consommation d'énergie ou un compromis défini comme un poids relatif entre ces deux paramètres,
- de préférence, on détermine, à partir de l'itinéraire final défini, les positions des stations recharge utilisées par le véhicule électrique et le niveau de recharge réalisé à chaque station de recharge utilisée par le véhicule électrique pour le trajet considéré.

Avantageusement, on considère plusieurs vitesses de circulation d'au moins une portion de route, chaque vitesse de circulation considérée étant comprise entre une première vitesse et une deuxième vitesse et on réitère l'étape b) pour chaque vitesse de circulation.

Selon une variante de l'invention, les portions de route prennent en compte la topographie du réseau routier, notamment la pente de la portion de route, l'infrastructure et la signalisation au moyen d'un système d'information géographique, les données de trafic au moyen d'un système de géolocalisation ou d'un système d'information géographique et de préférence les données météorologiques au moyen d'un système d'interface de programmation d'application. Préférentiellement, on acquiert une mesure, sur chaque portion de route du réseau routier, du profil de vitesse de plusieurs véhicules, au moyen d'un système de géolocalisation ou d'un téléphone embarqué pour déterminer, d'une part la vitesse moyenne des véhicules sur la portion de route, et d'autre part la probabilité d'arrêt des véhicules à la fin de la portion de route considérée, la probabilité d'arrêt étant déterminée par le pourcentage de véhicule pour lequel un arrêt est considéré à la fin de la portion de route, l'arrêt du véhicule étant considéré si, sur au moins un point de mesure de la deuxième moitié de la portion de route, une vitesse du véhicule est inférieure à une valeur prédéfinie, la valeur prédéfinie étant de préférence inférieure ou égale à 10 km/h.

Selon une configuration de l'invention, les stations de recharge considérées par le planificateur d'itinéraires ont une puissance supérieure ou égale à 50kW.

Selon un mode de réalisation de l'invention, les caractéristiques physiques du véhicule électrique comprennent sa masse et sa consommation énergétique.

Avantageusement, à l'étape c), on identifie la capacité de la batterie comme la capacité la plus petite parmi les capacités potentielles permettant un temps de trajet inférieur ou égal à une durée de trajet prédéterminée et/ou une consommation d'énergie inférieure ou égale à une consommation prédéterminée.

L'invention concerne aussi une méthode de construction d'un véhicule électrique, dans laquelle on identifie la capacité de la batterie à partir de la méthode de dimensionnement selon l'une des variantes ou combinaisons de variantes décrites précédemment, et on implante ladite batterie de capacité identifiée dans le véhicule électrique.

L'invention concerne également un produit programme d'ordinateur téléchargeable depuis un réseau de communication et/ou enregistré sur un support lisible par ordinateur et/ou exécutable par un processeur ou un serveur, comprenant des instructions de code de programme pour la mise en oeuvre de la méthode de dimensionnement selon l'une des variantes ou combinaisons de variantes décrites précédemment, lorsque ledit programme est exécuté sur un ordinateur, un téléphone portable ou un appareil informatique.

## Liste des figures

D'autres caractéristiques et avantages de la méthode et du produit selon l'invention, apparaîtront à la lecture de la description ci-après d'exemples non limitatifs de réalisations, en se référant aux figures annexées et décrites ci-après.

La figure 1 représente un mode de réalisation de la méthode de dimensionnement selon l'invention.

La figure 2 illustre un exemple de planificateur d'itinéraire adapté à la méthode de dimensionnement selon l'invention.

La figure 3 représente un exemple de profil de vitesse du véhicule électrique sur une portion de route pour la détermination de la probabilité d'arrêt à la fin de la portion de route, selon l'invention.

**Description des modes de réalisation**

L'invention concerne une méthode de dimensionnement d'une batterie d'un véhicule électrique pour implémenter la batterie dans ledit véhicule électrique.

Grâce à la méthode de l'invention, il est possible d'optimiser la taille de la batterie au strict nécessaire, en fonction du type de trajet à effectuer, et ce en évitant un surdimensionnement de la batterie.

La méthode sert ainsi à dimensionner la batterie en fonction d'un ou de plusieurs trajets types (de préférence des trajets longue distance d'au moins 200km et de manière préférée, d'au moins 500 km) que l'on souhaite réaliser avec le véhicule électrique dans un espace prédéterminé (un territoire donné physique correspondant à l'espace prédéterminé). Elle ne cherche pas à optimiser seulement le temps de trajet mais vise un compromis entre le temps de trajet, la consommation d'énergie et la taille de la batterie, par exemple en visant un temps de trajet acceptable pour l'utilisateur et en évitant un surdimensionnement de la batterie. Elle peut prendre en compte par exemple la fréquence du trajet type concerné.

Selon l'invention, l'espace prédéterminé comprend un réseau routier, le réseau routier comprenant des portions de route (aussi appelées segments de route) reliées entre elles par des intersections (ou carrefours). Les intersections peuvent ainsi correspondre à des points du réseau routier et les portions de route à des arcs reliant les points du réseau routier.

Pour ce faire, la méthode utilise les données d'entrées suivantes :

- les caractéristiques physiques dudit véhicule électrique : par exemple son rendement énergétique et la consommation énergétique des accessoires tels que la climatisation ou du radiateur pour chauffer l'habitacle ;
- le choix d'au moins un trajet, chaque trajet étant défini par une origine et une destination dans un espace prédéterminé, le trajet allant de l'origine vers la destination ;
- les localisations de stations de recharge (aussi appelées « bornes de recharge ») existantes dans l'espace prédéterminé : autrement dit, les localisations où il est possible de recharger la batterie du véhicule dans l'espace prédéterminé :
- de la puissance de chacune desdites stations de recharge. En effet, les puissances des différentes stations de recharge ne sont pas toutes identiques. Ainsi, le temps de recharge d'un même véhicule électrique peut varier d'une station à l'autre en fonction de la puissance disponible.

Au sens de l'invention, les « stations de recharge » (aussi appelées « bornes de recharge ») concernent des stations de recharge pour véhicules électriques, plus précisément pour recharger les batteries des véhicules électriques.

Un véhicule électrique s'entend d'un véhicule comprenant uniquement un moteur électrique alimenté en énergie par une batterie. En d'autres termes, ce véhicule n'a pas de moteur à combustion interne, tel qu'un moteur essence ou un moteur Diesel.

La méthode utilise également un planificateur d'itinéraire.

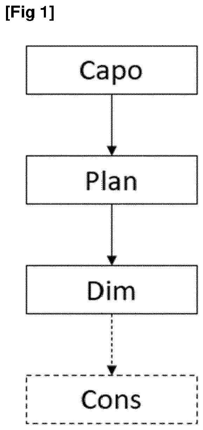

La figure 1 illustre, de manière schématique et non limitative, un mode de réalisation de la méthode de dimensionnement de la batterie d'un véhicule électrique selon l'invention.

La méthode de dimensionnement comprend au moins les étapes suivantes :

a) on définit plusieurs capacités potentielles de la batterie (Capo), lesdites capacités potentielles étant comprises entre une première valeur et une deuxième valeur ;
b) pour chaque capacité potentielle de la batterie, on utilise le planificateur d'itinéraires (Plan) pour déterminer au moins un itinéraire possible dudit trajet, chaque itinéraire possible étant défini par une succession de portions de route, et on détermine le temps de parcours pour parcourir l'itinéraire possible par ledit véhicule électrique et/ou la consommation d'énergie par ledit véhicule électrique de chaque itinéraire possible ainsi que la position des stations de recharge à utiliser par le véhicule électrique sur chaque itinéraire possible pour recharger sa batterie et le niveau de recharge associé.
c) à partir des temps de parcours et consommation d'énergie déterminées pour chaque capacité potentielle de batterie et de la taille (de son encombrement et/ou de son poids et/ou de sa capacité) de chaque capacité potentielle de batterie, on identifie la capacité de la batterie (Dim) parmi lesdites capacités potentielles.

En outre, la figure 1 comprend une autre étape facultative qui consiste à construire (Cons) le véhicule électrique en implémentant la batterie ainsi dimensionnée (c'est-à-dire en implémentant la batterie correspondante à la capacité identifiée à l'étape c)) dans le véhicule électrique. Cette étape facultative est matérialisée par les traits pointillés.

Selon l'invention, au moins l'étape b) est mise en oeuvre par des moyens informatiques, notamment un ordinateur ou un serveur, et de préférence, toutes les étapes sont mises en oeuvre par des moyens informatiques. Ainsi, le procédé peut être implémenté facilement dans un ordinateur ou un serveur.

**Etape a) de définition des capacités potentielles de la batterie**

Lors de cette étape, on choisit plusieurs capacités potentielles pour la batterie. Les capacités potentielles sont les capacités qu'il est possible d'implémenter dans le véhicule électrique concerné. Il peut s'agir des différentes batteries proposées par le fabricant du véhicule ou de batteries disponibles de manière plus large sur le marché et compatible avec le véhicule électrique concerné (les batteries compatibles peuvent être par exemple celles qui peuvent être montées dans le compartiment prévu à cet effet, compte tenu de l'espace disponible). La première valeur peut correspondre à la capacité minimale des batteries proposées par le fabricant du véhicule ou à une capacité minimale pour répondre aux principaux consommateurs du véhicule.

La deuxième valeur peut correspondre à la capacité maximale des batteries proposées par le fabricant du véhicule ou à la capacité maximale de batteries disponibles sur le marché et compatibles avec le véhicule.

Par exemple, les capacités potentielles peuvent être choisies de manière incrémentale entre la première valeur et la deuxième valeur, avec un pas prédéterminé, par exemple de 5 kWh. Cette approche permet de dimensionner la batterie au plus juste du besoin de l'utilisateur.

Alternativement, les capacités potentielles peuvent correspondre à toutes les tailles de batteries proposées par le fabricant du véhicule. Ainsi, on peut choisir la batterie en fonction des options proposées par le fabricant.

**Etape b) de planification d'itinéraires**

Pour chaque capacité potentielle de la batterie définie à l'étape a), on cherche à déterminer plusieurs paramètres importants pour le dimensionnement de la batterie et son choix définitif. Ces paramètres à déterminer sont notamment :

- le temps de parcours pour réaliser le trajet considéré (de l'origine vers la destination) avec le véhicule électrique équipé de la batterie pour chacune des capacités potentielles. En effet, la capacité potentielle de la batterie impacte directement le temps (ou la distance) entre deux recharges. En outre, plus la capacité potentielle de la batterie est grande et plus de temps de recharge, en partant d'un même état initial de charge et jusqu'à un même état final de charge, est grand.
- La consommation énergétique pour réaliser le trajet considéré avec le véhicule électrique équipé de la batterie pour chacune des capacités potentielles. Ainsi, on peut voir l'impact de la consommation énergétique en fonction du choix de la capacité potentielle de la batterie.
- Le nombre d'arrêts pour recharge sur le trajet considéré et la position des stations de recharge utilisées par le véhicule électrique. En effet, pour une plus petite capacité potentielle, le véhicule électrique risque s'arrêter plus souvent qu'avec un véhicule équipé d'une plus grande capacité potentielle. La position des stations de recharge utilisée impacte le temps de recharge car la puissance disponible aux différentes stations peut être différente. Ainsi, en fonction des positions des stations de recharge utilisées, le temps de recharge et donc le temps de trajet peut différer.
- Le niveau de recharge à chaque station de recharge utilisé. En effet, il peut être judicieux de ne pas recharger le véhicule électrique jusqu'à 100%. En effet, la loi de recharge de la batterie n'est généralement pas linéaire avec le temps. Par exemple, la recharge du véhicule peut être rapide lorsque le niveau de charge du véhicule se situe entre 30% et 80% mais être plus lente après 80% et encore plus lente après 90%.

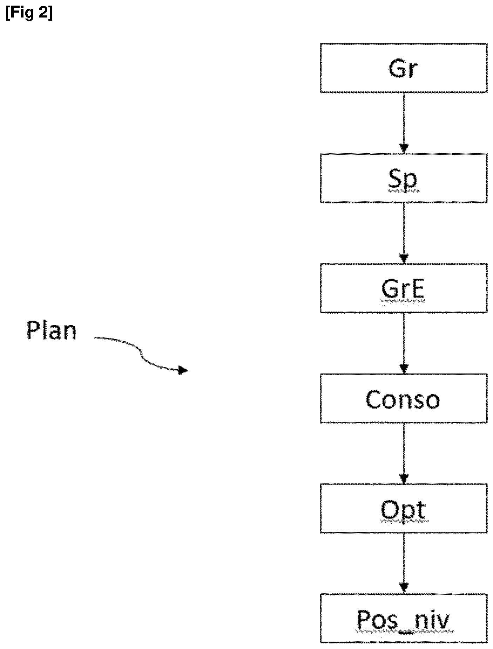

Le planificateur d'itinéraires propose ainsi, pour chaque trajet considéré et pour chaque capacité potentielle de la batterie du véhicule électrique, un itinéraire possible défini par une succession de portions de route sur le graphe routier et il propose des arrêts à de stations de recharge, lorsque la recharge de la batterie est nécessaire sur le trajet, la position des stations de recharge utilisées et le niveau de recharge à chacune des stations de recharge utilisées. Selon une configuration de l'invention, telle qu'illustrée à la figure 2, à l'étape b), le planificateur d'itinéraires peut par exemple réaliser au moins les étapes suivantes :

- on peut construire (Gr) un graphe de routage à partir du réseau routier, les sommets du graphe de routage représentant les intersections de chaque portion de route (PR) et les arcs du graphe de routage représentant les portions de route (PR). En d'autres termes, le graphe de routage représente le réseau routier du territoire considéré (de l'espace prédéterminé).
- on peut positionner (Sp) les stations de recharge (existantes) sur le graphe de routage, et de préférence, on associe à chaque station de recharge positionnée sur le graphe de routage, un niveau de puissance disponible pour la recharge. Ainsi, le temps de recharge peut être différent d'une station de recharge à l'autre, en fonction de la puissance disponible, pour un même véhicule avec une même capacité potentielle de batterie.

- on peut étendre (GrE) le graphe de routage en multipliant au moins certains arcs en fonction de paramètres prédéfinis, les paramètres prédéfinis comprenant la vitesse de circulation sur la portion de route considérée et/ou le niveau de recharge lors de l'arrêt à une station de recharge. Chaque arc du graphe étendu correspond ainsi à un déplacement le long de chaque portion de route avec un ou plusieurs paramètres distincts : par exemple, plusieurs vitesses de déplacement différentes et/ou plusieurs niveaux de recharge différents pour chaque arc reliant deux mêmes sommets. De ce fait, le planificateur d'itinéraires peut rechercher le niveau de recharge optimal pour limiter le temps de trajet ou la consommation d'énergie, par exemple en évitant de recharger systématiquement le véhicule à 100% de la batterie.

On peut utiliser différentes vitesses de circulation en réduisant cette vitesse par rapport à la vitesse maximale autorisée sur au moins certaines portions de route ou par rapport à la vitesse moyenne de circulation sur certaines portions de route. Les portions de route concernées par cette réduction de vitesse peuvent être identifiées par exemple par une vitesse de déplacement moyenne supérieure à un certain seuil, pour identifier les portions d'autoroute par exemple. Ainsi, on multiplie le graphe de chaque portion de route concernée par autant de vitesse moyenne envisagée pour cette portion de route. Par exemple, on peut envisager plusieurs réductions de vitesse possibles par rapport à la vitesse du trafic ou à la vitesse maximale autorisée. Avantageusement, les réductions de vitesse envisagées dans le planificateur d'itinéraires peuvent être de 0, 5, 10 et 15km/h. Ainsi, chaque arc des portions de route concernée peut être multiplié par quatre arcs dans le graphe de routage étendu correspondant aux choix des réductions de vitesse envisagées possibles.

Ces certaines portions de route peuvent notamment être des portions d'autoroute où la vitesse maximale autorisée est généralement supérieure à 100km/h par exemple. La réduction de la vitesse permet de limiter la consommation d'énergie, et donc elle peut permettre de supprimer quelques arrêts pour recharger la batterie.

- on peut déterminer (Conso) un modèle de consommation énergétique, le modèle énergétique définissant la consommation d'énergie du véhicule électrique en fonction de paramètres prédéterminés en prenant en compte les recharges éventuelles de la batterie du véhicule électrique. Ainsi, à chaque point de l'itinéraire, on peut connaître, grâce au planificateur d'itinéraire, le niveau de charge de la batterie.

- pour chaque trajet, on peut appliquer le modèle de consommation énergétique sur les différents arcs du graphe routage étendu et on peut définir comme itinéraire final du trajet possible, l'ensemble des arcs permettant de minimiser (Opt), par un algorithme d'optimisation tel qu'un algorithme du plus court chemin de Bellman-Ford, le temps de parcours, ou la consommation d'énergie ou un compromis défini comme un poids relatif entre ces deux paramètres. L'algorithme permet de minimiser le temps de parcours ou la consommation d'énergie ou de trouver un mix entre ces deux paramètres. - Optionnellement, on peut déterminer (Pos_niv), à partir de l'itinéraire final défini, les positions des stations recharge utilisées par le véhicule électrique et le niveau de recharge réalisé à chaque station de recharge utilisée par le véhicule électrique pour le trajet considéré. Ainsi, l'utilisateur sait quelles stations de recharge sont à utiliser sur l'itinéraire et quel est le niveau de recharge à atteindre afin d'optimiser l'itinéraire. Il sait donc combien de fois il doit s'arrêter sur son itinéraire final et où il convient de s'arrêter pour recharger sa batterie.

Avantageusement, la première variable d'extension du graphe de routage peut être la vitesse de déplacement à adopter sur certaines portions de route le long de l'itinéraire afin de trouver le bon compromis entre le temps du trajet et la consommation énergétique. En d'autres termes, sur certaines portions de la route notamment à grande vitesse, il peut être intéressant de rouler à une vitesse inférieure à la vitesse moyenne du trafic ou à la vitesse maximale autorisée afin de réduire la consommation d'énergie, et donc de réduire la quantité d'énergie nécessaire pour effectuer le trajet, ce qui peut se traduire par une réduction du nombre d'arrêts pour recharger la batterie. Les portions de route concernées par cette réduction de vitesse peuvent être identifiées par exemple par une vitesse de déplacement moyenne supérieure à un certain seuil, pour identifier les portions d'autoroute par exemple. Ainsi, on multiplie le graphe de chaque portion de route concernée par autant de vitesses moyennes envisagées pour cette portion de route. Par exemple, on peut envisager plusieurs réductions de vitesse possibles par rapport à la vitesse du trafic ou à la vitesse maximale autorisée. Avantageusement, les réductions de vitesse envisagées dans le planificateur d'itinéraires peuvent être de 0, 5, 10 et 15km/h. Ainsi, chaque arc des portions de route concernée est multiplié par quatre arcs dans le graphe de routage étendu correspondant aux choix des réductions de vitesse envisagées possibles.

Additionnellement ou alternativement, la deuxième variable d'extension du graphe de routage peut être le niveau de recharge à chaque station de recharge utilisé. Par conséquent, le graphe de routage peut être étendu pour contenir autant de copies des arcs sortants des sommets correspondant à une station de recharge utilisées que de niveaux prédéfinis de récupération d'énergie de la batterie pendant la charge. Par exemple, les niveaux de recharge autorisés peuvent correspondre à {0,10,20, ...,100}%, avec un pas de 10%. Ainsi, chaque arc sortant des sommets des stations de recharge potentielles dans le graphe de routage étendu est multiplié par onze arcs dans le graphe de routage étendu pour toutes les valeurs prédéfinies possibles de niveau de recharge.

De préférence, les portions de route peuvent prendre en compte la topographie du réseau routier, notamment la pente de la portion de route, l'infrastructure et la signalisation au moyen d'un système d'information géographique, les données de trafic au moyen d'un système de géolocalisation ou d'un système d'information géographique (SIG) et de préférence les données météorologiques au moyen d'un système d'interface de programmation d'application (une API qui signifie « application programming interface » en anglais).

La prise en compte de la pente impacte directement la consommation d'énergie.

La prise en compte des infrastructures routières et de signalisation permet de tenir compte des feux de signalisation, des panneaux « cédez le passage » ou « stop » où un arrêt peut avoir lieu, des limitations de vitesse ou des ralentisseurs par exemple. Tous ces éléments peuvent impacter la vitesse moyenne et le profil de vitesse sur une portion de route.

Par profil de vitesse, on entend la variation (ou courbe) représentative des vitesses instantanées le long de la portion de route. Le profil de vitesse peut se représenter par une courbe de la vitesse instantanée en fonction de la distance le long de la portion de route. Le profil de vitesse tient ainsi compte des accélérations et décélérations qui peuvent se produire sur la portion de route, ce que ne permet pas la seule information de la vitesse moyenne. Ce profil de vitesse peut notamment être établi à partir de mesures des véhicules électriques ou non se déplaçant sur le réseau routier. Par exemple, ce profil de vitesse peut être établi à partir des données issues de l'application Geco air® (IFP Energies nouvelles, France) qui enregistre les vitesses des usagers sur les portions de route. Geco air® est une application pour réduire la pollution liée aux déplacements et pour ce faire, elle collecte les données de position et de vitesses instantanées.

Les données de trafic permettent la prise en compte de la densité du trafic et son impact sur la vitesse moyenne. Les données de trafic peuvent notamment correspondre à la vitesse moyenne et/ou la durée de trajet des véhicules sur la portion du réseau routier par tranches horaires, par exemple toutes les dix minutes. Pour cela, on peut par exemple mesurer la vitesse moyenne au cours de la journée, de préférence sur plusieurs jours. Ainsi, on peut récupérer un historique du trafic et sa variation journalière enregistrés au cours de la journée. En appliquant les données de trafic, on peut évaluer plus précisément le temps de parcours et/ou la consommation énergétique en fonction du jour et de l'horaire considéré et/ou en fonction des données de trafic en temps réel.

Les données météorologiques, notamment de températures, sont également intéressantes pour la détermination de la consommation énergétique si le chauffage ou la climatisation du véhicule sont activés. Pour ce faire, on peut utiliser une API météo REST, comme l'API de « Météo France ™», pour récupérer les conditions météorologiques en temps réel au départ et les mettre à jour régulièrement le long de l'itinéraire, par exemple à des intervalles de temps (notamment toutes les heures) ou d'espace (par exemple, tous les 60 km) fixes. Des méthodes d'interpolation peuvent ensuite être utilisées pour obtenir des informations météorologiques sur chaque portion de route. La température ambiante peut être obtenue pour chaque portion de route en interpolant les prévisions de température obtenues de l'API météo.

La topographie peut être supposée être invariante dans le temps, ou varier dans le temps. Par conséquent, ces données peuvent être stockées hors ligne sur des bases de données locales pour un calcul d'itinéraire en ligne plus rapide. Pour alimenter une telle base de données hors ligne, on peut par exemple utiliser les services web REST (« Representational State Transfer », signifiant Transfert de la Représentation d'Etats) de fournisseurs de données cartographiques et de localisation, par exemple HERE Maps.

Chaque portion de route peut également être classée en fonction de sa topologie, notamment avec une classe "fonctionnelle" associée, allant par exemple de 1 pour les autoroutes principales à 5 pour les rues urbaines secondaires. En outre, chaque portion de route peut être définie par un identifiant unique et par sa géométrie avec des coordonnées tridimensionnelles (au moins les coordonnées des deux extrémités de la portion de route). Les coordonnées peuvent de préférence être exprimées en latitude, longitude et altitude au-dessus du niveau de la mer. Enfin, le type d'intersection et/ou de signalisation à l'extrémité avale de chaque portion de route peut également être récupéré : on peut notamment prendre en compte les types d'infrastructure routière et de signalisation comme les feux de signalisation, les panneaux d'arrêt, les panneaux de céder le passage, les ronds-points et les postes de péage.

Selon une configuration de l'invention, on peut acquérir une mesure (ou mesurer), sur chaque portion de route du réseau routier, du profil de vitesse de plusieurs véhicules, au moyen d'un système de géolocalisation ou d'un téléphone embarqué pour déterminer, d'une part, la vitesse moyenne des véhicules sur la portion de route, et d'autre part la probabilité d'arrêt des véhicules à la fin de la portion de route considérée, la probabilité d'arrêt étant déterminée par le pourcentage de véhicules pour lequel un arrêt est considéré à la fin de la portion de route, l'arrêt du véhicule étant considéré si, sur au moins un point de mesure de la deuxième moitié de la portion de route, une vitesse du véhicule est inférieure à une valeur prédéfinie, la valeur prédéfinie étant de préférence inférieure ou égale à 10 km/h. De ce fait, on tient compte des statistiques d'arrêt à la fin de la portion de route, par exemple en raison d'un feu de signalisation, d'un panneau « stop » ou « cédez-le-passage », d'un péage d'autoroute. Lorsque l'arrêt se produit, il impacte directement le profil de vitesse, la vitesse moyenne sur la portion de route et donc il exerce une influence sur le temps de parcours et sur la consommation énergétique du véhicule.

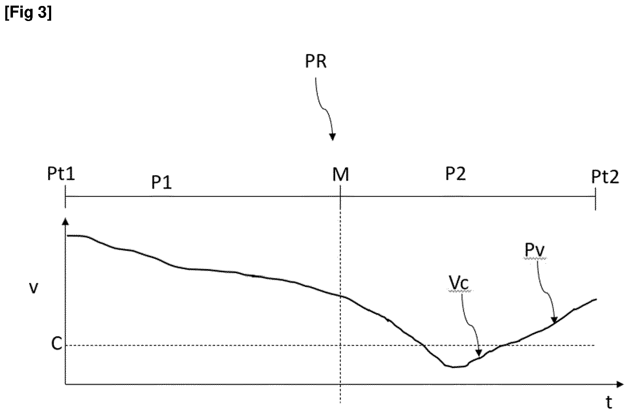

La figure 3 illustre, de manière schématique et non limitative, un exemple de profil de vitesse d'un véhicule utilisé pour déterminer la probabilité d'arrêt.

Sur cette figure, la courbe noire illustre le profil de vitesse Pv du véhicule sur une portion de route PR. Ce profil de vitesse Pv définit la vitesse instantanée v du véhicule au cours du temps t en allant de l'intersection Pt1 à l'intersection Pt2. La portion de route PR comprend une première moitié P1 et une deuxième moitié P2, en aval de P1 dans le sens de circulation du véhicule sur la portion de route PR. Le point M représente le milieu de la portion de route PR et correspond donc au point séparant la première moitié P1 de la deuxième moitié P2.

Le profil de vitesse Pv montre des vitesses instantanées variables le long de la portion de route PR. Notamment, une partie Vc du profil de vitesse Pv comprend des vitesses instantanées inférieures au critère C. Dans ce cas, comme au moins une vitesse instantanée de la partie Vc située sur la deuxième partie P2 de la portion de route T1 est inférieure au critère prédéfini C, on considère que ce véhicule s'arrête dans la deuxième portion P2 de la portion de route PR.

Avantageusement, le type d'intersection et/ou de signalisation peut être utilisé pour déterminer la probabilité d'arrêt (c'est-à-dire que la vitesse du véhicule passe à zéro) à l'élément d'infrastructure correspondant. Cette probabilité d'arrêt peut alors remplacer la vitesse moyenne du trafic et être utilisée pour affiner le comportement de conduite prédit. Un tel modèle probabiliste simple peut être obtenu par une méthode de classification mettant en relation le comportement d'arrêt avec le type d'intersection, la classe fonctionnelle de la portion de route considérée et l'heure de la journée afin de saisir l'impact du trafic de pointe et hors pointe.

Selon une mise en oeuvre avantageuse de l'invention, le planificateur d'itinéraire peut comprendre un modèle de temps de parcours, c'est-à-dire un modèle pour estimer le temps nécessaire pour parcourir une portion de route.

L'estimation du temps de parcours sur un arc du graphe peut être issue de l'API de routage, par exemple en fonction des conditions de trafic en temps réel, ce temps de parcours étant noté $\overline{T}_i$, Sur les arcs où la vitesse est réduite par rapport à la vitesse moyenne de circulation $\overline{V}_l$ (ou par rapport à la vitesse maximale autorisée), le temps de parcours $\overline{T}_{i,v}$ augmente par rapport à $\overline{T}_i$ et peut être calculé comme suit :

$$\overline{T}_{i,v} = \overline{T}_i + \delta_v \frac{L_i}{\overline{V}_l(\overline{V}_l - \delta_v)}$$

Avec $L_i$ la longueur de la portion de route et $\delta_v$ la réduction de la vitesse considérée sur la portion de route par rapport à la vitesse moyenne de circulation.

Additionnellement ou alternativement, sur les arcs où se produisent une recharge de la batterie du véhicule au niveau d'une station de recharge, l'estimation du temps de parcours $\overline{T}_{i,c}$ peut également tenir compte de plusieurs contributions comme suit :

$$\overline{T}_{i,c} = \begin{cases} \overline{T}_i, & si\ \delta_c = 0 \\ \overline{T}_i + T_d + T_s + T_c, & si\ \delta_c > 0 \end{cases}$$

Où le temps de parcours issu de l'API de routage $\overline{T}_i$ pourrait être remplacé par $\overline{T}_{i,v}$ pour tenir compte de la réduction de vitesse souhaitée sur l'arc considéré si, sur l'arc, il y a une option de réduction de vitesse comme discuté précédemment

Et où le deuxième terme $T_d$ est le temps de détour nécessaire pour atteindre l'emplacement du chargeur hors route. Ce terme dépend de la distance du sommet le plus proche du graphe de routage et de la vitesse moyenne supposée du détour.

Le troisième terme $T_s$ est constant et représente le temps passé après l'arrêt du véhicule pour interagir avec le chargeur et préparer la charge.

Le quatrième terme $T_c$ correspond au temps de charge réel, qui dépend l'état de charge initial de la batterie au début de la charge, de l'état de charge final, qui n'est pas nécessairement de 100% comme expliqué précédemment, de la capacité de la batterie et de la puissance du chargeur.

$\delta_c$ est le niveau de recharge sur la portion de route considérée.

Afin d'estimer correctement le temps de charge $T_c$, un modèle simple inspiré de la méthode de recharge CC-CV (« constant-current constant-voltage » pour courant constant -tension constante), avec une phase de précharge lorsque la capacité de la batterie est faible, tel que celui décrit dans le document « F. A. V. Pinto, L. H. M. K. Costa, and M. D. de Amorim, "Modeling Spare Capacity Reuse in EV Charging Stations based on the Li-ion Battery Profile," in International Conférence on Connected Vehicles and Expo (ICCVE), 2014, pp. 92-98 », peut être utilisé.

Avantageusement, le planificateur d'itinéraire peut également comprendre un modèle de pilotage. Afin d'estimer avec précision la consommation d'énergie nécessaire au déplacement sur un arc du graphe de routage, la première étape consiste à prédire le comportement du conducteur sur le segment de route (aussi appelé portion de route), afin de prévoir la demande de puissance de traction du véhicule. On peut utiliser par exemple un modèle tel que l'« Intelligent Driver Model » (IDM pouvant être traduit par modèle de conducteur intelligent) décrit dans le document : « [M. Treiber, A. Hennecke, and D. Helbing, "Congested Traffic States in Empirical Observations and Microscopic Simulations," Physical Review E, vol. 62, pp. 1805-1824, 2000 ]» pour générer des profils de vitesse synthétiques attendus sur chaque arc du graphe de routage, en fonction des données dynamiques du trafic. Ce modèle est un modèle de suivi de voiture qui décrit la dynamique de la position et de la vitesse des véhicules en interaction avec les véhicules précédents. Dans un cadre de planification d'itinéraire selon l'invention, comme il n'est pas possible de connaître précisément à l'avance le comportement des véhicules précédents le véhicule pour lequel l'itinéraire est optimisé pour la méthode selon l'invention, ce modèle peut être adapté pour être utilisé pour un véhicule sans interaction avec les véhicules précédents réels. Pour ce faire, on détermine la probabilité d'arrêt à la fin de la portion de route, tel que décrit précédemment dans cette description, et on suppose alors qu'un véhicule précédent virtuel apparaît pour perturber la vitesse du véhicule pour lequel l'itinéraire est calculé. On peut par exemple utiliser les données de l'application Geco air ® pour cela. La présence de ce véhicule précédent virtuel force une transition de vitesse vers une vitesse nulle, forçant ainsi l'arrêt à la fin de la portion de route considérée. Au contraire, lorsque la probabilité d'arrêt ne traduit pas un arrêt à la fin de la portion de route considérée, le véhicule pour lequel l'itinéraire est calculé atteint la vitesse moyenne de la portion de route suivante.

La dynamique de la vitesse dépend des conditions aux limites de la portion de route du réseau routier considéré, et en particulier de la présence d'un événement d'arrêt à l'extrémité (intersection) amont et/ou aval de cette portion de route. Si aucun d'arrêt n'est prévu à l'extrémité (intersection) avale de la portion de route, seul le terme de route libre apparaît dans la dynamique de la vitesse :

$$\dot{x}(t) = v(t)$$

$$\dot{v}(t) = a\left(1 - \left(\frac{v(t)}{V_T}\right)^{\gamma}\right) = \dot{v}_{free}$$

Où *a* est l'accélération maximale du véhicule, v la vitesse du véhicule et x sa position, *γ* peut être considéré comme un paramètre de réactivité du conducteur, et $V_T$ est la vitesse cible du véhicule.

$v_{free}$ correspond à la vitesse de route libre, c'est-à-dire sans arrêt à l'extrémité (intersection) avale de la portion de route.

La vitesse cible $V_T$ peut être fixée en fonction de la longueur $L_i$ de la portion de route et de la position du véhicule pour lequel l'itinéraire est calculé comme suit :

$$V_T = \begin{cases} \overline{V}_i, & if\ x(t) < \max\{0, L_i - d_h\} \\ \overline{V}_{i+1}, & if\ x(t) \geq \max\{0, L_i - d_h\} \end{cases}$$

Où $\overline{V}_i$ est la vitesse moyenne de déplacement sur l'arc *i*, $\overline{V}_{i+1}$ est la vitesse de déplacement sur l'arc suivant *i* + 1, $d_h$ est la longueur de l'horizon de prédiction du conducteur, c'est-à-dire un paramètre qui indique la distance à partir de laquelle le conducteur commence à cibler la vitesse de la portion de route suivante.

De plus, la vitesse initiale peut être fixée à zéro s'il y a une probabilité d'arrêt à la fin de l'arc (de la portion de route) amont, et à $\overline{V}_i$ sinon.

D'autre part, si un arrêt est prédit à l'intersection avale de la portion de route, la dynamique de la vitesse peut également inclure un terme d'interaction et un véhicule précédent virtuel peut être supposé influencer le comportement du véhicule pour lequel l'itinéraire peut être calculé, comme suit :

$$\dot{v}(t) = \dot{v}_{free} - a\left(\frac{d_0 + v(t)T_h}{x(t)} + \frac{v(t)(v(t) - v_l)}{2\sqrt{ab}x(t)}\right)^2,$$

où $d_0$ est l'inter-distance minimale par rapport au véhicule précédent virtuel, $T_h$ est la distance minimale par rapport au véhicule précédent virtuel, et *b* est une accélération de freinage prédéterminée. La vitesse du véhicule précédent virtuel *v_l* peut être calculée comme suit :

$$v_l = \begin{cases} \bar{V}_{i+1}, & if\ x(t) < \max\{0, L_i - d_h\} \\ 0, & if\ x(t) \geq \max\{0, L_i - d_h\} \end{cases}$$

Si le véhicule précédent virtuel est arrêté (*v_l* = 0), le véhicule pour lequel l'itinéraire est calculé ne peut s'arrêter exactement à la fin de la portion de route, compte tenu du fait qu'on suppose que le véhicule précédent virtuel s'arrête à la fin de la portion et qu'on tient compte de l'interdistance $d_0$ et de la longueur du véhicule lui-même.

Avantageusement, le planificateur d'itinéraire peut également comprendre un modèle de consommation énergétique.

La consommation d'énergie du véhicule électrique est calculée au moyen de sa dynamique et de la modélisation du groupe motopropulseur afin d'estimer précisément les pertes de l'entraînement électrique et de l'absorption de puissance auxiliaire. La force d'entraînement $F_w$ pour entraîner les roues du véhicule en rotation, pour une vitesse donnée *v(t)* (c'est-à-dire la vitesse fournie par le modèle de pilotage décrit précédemment) peut être définie comme suit :

$$F_w(t) = m\dot{v}(t) + c_2 v(t)^2 + c_1 v(t) + c_0 + mg \sin \alpha$$

où *m* est la masse du véhicule, *g* est l'accélération gravitationnelle, $\alpha$ est la pente de la route qui varie le long de la portion de route, et les coefficients $c_0$, $c_1$ et $c_2$ sont identifiés pour un véhicule électrique considéré. La force de la roue $F_w$ peut être convertie en puissance mécanique $P_m$ demandée au système de propulsion :

$$P_m(t) = F_w(t)v(t)\eta_t^{-sign(F_w(t))}$$

où $\eta_t$ est l'efficacité de la transmission.

Enfin, la consommation d'énergie $E_b$ de la batterie peut être définie comme suit :

$$E_b = \int_0^{t_f} P_m(t)\eta_b^{-sign(P_m(t))} + P_{aux}\ dt$$

où $\eta_b$ représente l'efficacité de la propulsion électrique, $t_f$ est le temps de parcours de la portion de route, et $P_{aux}$ est l'absorption de puissance auxiliaire le long de la portion de route. Par exemple, la demande d'énergie auxiliaire peut être supposée provenir principalement de la climatisation de l'habitacle ou des besoins de confort du conducteur, et elle peut être une fonction convexe de la température ambiante, disponible sur chaque portion de route.

Selon une variante de l'invention, l'algorithme d'optimisation peut être défini par un problème d'optimisation conçu pour trouver le meilleur compromis entre le temps de trajet et/ou la consommation d'énergie.

Le problème d'optimisation peut être formulé comme suit :

$$\min_{x_\zeta} \sum_{\zeta \in A^*} (\lambda\omega_t + (1-\lambda)\omega_e)x_\zeta$$

$$s.t. \sum_{\zeta \in i^+} x_\zeta - \sum_{\zeta \in i^-} x_\zeta = \begin{cases} 1, & if\ i = i^o \\ -1, & if\ i = i^d \\ 0, & sinon \end{cases}$$

$$C_{min} \leq \sum_{\zeta \in \mathcal{P}_i} \omega_e \leq C, \forall i \in A'$$

$x_\zeta \in \{0,1\}$

Avec

$\zeta$ désignant les arcs d'un graphe linéaire $\mathcal{L}(\mathcal{G})$ obtenu à partir du graphe de routage étendu $\mathcal{G}$, le graphe linéaire possédant un sommet représentant chaque arc du graphe de routage étendu et chaque arc du graphe linéaire représentant une paire d'arcs adjacents du graphe de routage étendu.

$i^+$ l'ensemble des arcs $\zeta$ entrants,

$i^-$ l'ensemble des arcs $\zeta$ sortants,

$i^o$ l'arc d'origine,

$i^d$ l'arc de destination,

$\mathcal{P}_i$ l'itinéraire composé par tous les arcs $\zeta$ reliant l'origine $i^o$ à $i^d$,

$\omega_t$ le coût en temps,

$\omega_e$ le coût en énergie,

$x_\zeta$ la variable de décision qui est de 0 si l'arc concerné n'appartient pas à l'itinéraire ou de 1, s'il appartient à l'itinéraire

$\lambda$ le poids du compromis,

A' représentent l'ensemble des arcs du graphe de routage étendu,

$C_{min}$ : un état de charge minimal acceptable de la batterie

C : état de charge de la batterie

Ainsi, le problème d'optimisation est une fonction objectif qui s'écrit comme une somme pondérée des coûts en temps $\omega_t$ et coûts en énergie $\omega_e$ sur chaque arc du graphe de routage, tels qu'estimés par les modèles de temps de trajet et de consommation d'énergie décrits précédemment. Le poids du compromis est noté $\lambda$. La variable de décision $x_\zeta$ prend des valeurs binaires selon que l'arc $\zeta$ appartient ou non à l'itinéraire. La deuxième contrainte est une contrainte classique de conservation du flux. La troisième contrainte impose à chaque partie d'itinéraire possible de vérifier les limites physiques de la capacité de la batterie, désignée par C. Pour réduire l'inquiétude concernant l'autonomie, l'état de charge minimal de la batterie $C_{min}$ peut être strictement supérieur à zéro, par exemple supérieur à une valeur de charge minimale prédéfinie.

De manière préférée, l'algorithme d'optimisation peut être un algorithme du plus court chemin de Bellman-Ford pour garantir l'optimalité de la solution de routage afin d'éviter notamment les valeurs négatives en raison de la présence du terme d'énergie.

En considérant différentes capacités potentielles pour la batterie, on peut ainsi voir l'évolution en termes de temps de trajet, de consommation énergétique, de nombre d'arrêts, des positions d'arrêts pour recharge et du niveau de recharge de chaque arrêt.

De préférence, lorsqu'on considère plusieurs vitesses de circulation sur au moins une portion de route (pour tenir compte de réductions de vitesse par rapport à la vitesse moyenne de circulation ou à la vitesse maximale autorisée sur certaines portions de route), chaque vitesse de circulation considérée peut être comprise entre une première vitesse et une deuxième vitesse et on peut réitérer l'étape b) pour chaque vitesse de circulation. La première vitesse peut correspondre par exemple à la vitesse maximale autorisée ou à la vitesse moyenne de circulation sur la portion de route considérée réduite d'un critère prédéterminé, par exemple le critère prédéterminé peut être compris entre 10 et 40 km/h. La deuxième vitesse peut correspondre à la vitesse maximale autorisée ou à la vitesse moyenne de circulation sur la portion de route considérée.

De préférence, les stations de recharge considérées par le planificateur d'itinéraires peuvent avoir une puissance supérieure ou égale à 50kW. Ainsi, on peut choisir de ne pas tenir compte des stations de recharge qui ont une puissance inférieure et qui nécessiteraient trop de temps de recharge. Ces stations de recharge ne seraient donc pas pertinentes. En éliminant ces stations de recharge du planificateur d'itinéraires, on peut limiter la mémoire, accélérer le temps de calcul, sans affecter la pertinence des résultats issus du planificateur d'itinéraires.

Avantageusement, les caractéristiques physiques du véhicule électrique peuvent comprendre sa masse et sa loi de consommation énergétique. En effet, la masse du véhicule impacte directement sa consommation énergétique. La loi de consommation énergétique du véhicule peut dépendre de ses capacités aérodynamiques, de son rendement énergétique, des différents consommateurs d'énergie du véhicule, par exemple la climatisation de l'habitacle.

**Etape c) d'identification de la batterie**

L'étape b) a permis de déterminer plusieurs paramètres pour chaque itinéraire de chaque capacité potentielle de batterie du véhicule électrique (et éventuellement pour plusieurs vitesses de circulation pour au moins certaines portions de route). Lesdits paramètres peuvent être choisis parmi le temps de trajet qui tient compte des arrêts pour recharge et des temps de recharge, la consommation énergétique, le nombre d'arrêts pour recharge, la position des arrêts pour recharge ainsi que le niveau de recharge de chaque arrêt pour recharge.

On peut alors comparer ces différents paramètres pour choisir la capacité potentielle afin de l'implémenter (la monter) sur le véhicule électrique. Ainsi, parmi les différentes capacités potentielles définies à l'étape a), on identifie une de ces capacités potentielles comme la capacité de la batterie pour son implémentation dans le véhicule électrique. De ce fait, on dimensionne la capacité de la batterie.

On peut par exemple identifier (dimensionner) la capacité de la batterie comme la capacité la plus petite parmi les capacités potentielles permettant un temps de trajet inférieur ou égal à une durée de trajet prédéterminée et/ou une consommation d'énergie inférieure ou égale à une consommation prédéterminée. En effet, de cette manière, on peut viser une durée de trajet prédéterminée et/ou une consommation prédéterminée acceptable(s) par l'utilisateur. On peut identifier la batterie la plus petite qui permet d'atteindre cet (ou ces) objectifs de manière à éviter le surdimensionnement de la batterie qui a un impact environnemental plus grand. Alternativement, on peut identifier la capacité par d'autres moyens. On peut par exemple évaluer le gain en temps de trajet et/ou en consommation d'énergie et prendre la capacité à partir de laquelle le gain (en temps de trajet et/ou en consommation d'énergie par exemple) des batteries de capacités plus grandes devient inférieur à un certain critère.

Par gain, on entend réduction du temps de trajet ou de la consommation d'énergie d'une capacité donnée par rapport aux capacités potentielles plus grandes que ladite capacité donnée. Un gain négatif indique une augmentation du temps de trajet ou de la consommation d'énergie, ce qui n'a pas d'intérêt. Ainsi, au sens de l'invention, seuls les gains positifs sont pris en compte.

On peut aussi identifier la capacité de la batterie par une loi mathématique prédéterminée qui permet un compromis entre le temps de trajet, la consommation d'énergie et/ou éventuellement la taille (la capacité) de la batterie. Cette loi mathématique peut également prendre en compte la répartition annuelle des différents trajets afin de prendre en compte le poids relatif de différents trajets.

On peut aussi identifier la capacité de la batterie, en se basant sur un critère lié à la propension des utilisateurs d'accepter un nombre prédéfini d'arrêts sur le trajet ou bien en se basant sur un critère d'arrêt pour recharger la batterie à intervalles réguliers (par exemple toutes les 3 heures), notamment pour répondre aux critères de sécurité pendant la conduite. De ce fait, les arrêts nécessaires pour le repos du conducteur sont utilisés pour recharger la batterie.

**Etape facultative de construction**

Selon un mode de réalisation de l'invention, après avoir identifié la capacité de la batterie à partir de la méthode de dimensionnement telle que précédemment, on peut implanter (ou monter ou implémenter) ladite batterie de capacité identifiée dans le véhicule électrique. De ce fait, l'invention concerne aussi une méthode de construction d'un véhicule électrique dans laquelle on identifie la capacité de la batterie à partir de la méthode de dimensionnement telle que décrite, et on implante ladite batterie de capacité identifiée dans le véhicule électrique. Ainsi, la batterie identifiée et montée dans le véhicule électrique est optimisée en vue du ou des trajets de longue distance prévus, et ce en évitant de surdimensionner la batterie pour limiter les émissions de $CO_2$ générées sur toute la durée de vie de la batterie, notamment l'impact de la fabrication de la batterie et l'éventuel impact de recyclage de la batterie.

En outre, l'invention concerne un procédé de rétrofit (réaménagement) d'un véhicule qui comporte un groupe motopropulseur d'origine (par exemple un moteur thermique), dans lequel on met en oeuvre les étapes suivantes :

- On modifie le groupe motopropulseur du véhicule, par exemple en remplaçant un moteur thermique par une machine,
- On implémente une batterie électrique au sein du véhicule, la batterie électrique étant dimensionnée au moyen du procédé selon l'une quelconque des variantes ou des combinaisons de variantes décrites précédemment.

L'invention concerne également un produit programme d'ordinateur téléchargeable depuis un réseau de communication et/ou enregistré sur un support lisible par ordinateur et/ou exécutable par un processeur ou un serveur, comprenant des instructions de code de programme pour la mise en oeuvre de la méthode de dimensionnement telle que décrite précédemment, lorsque ledit programme est exécuté sur un ordinateur, un téléphone portable ou un appareil informatique. De ce fait, l'utilisation de la méthode est simple et rapide.

**Exemples**

La méthode de dimensionnement d'une batterie de véhicule électrique a été utilisée pour dimensionner la batterie d'une Fiat 500E en vue d'un trajet longue distance de Stuttgart en Allemagne à Nice en France, en passant à travers les Alpes. Ce trajet fait environ 800 km. Les informations topographiques ont été obtenues par HERE Maps. Les positions des différentes stations de recharge existantes ont été récupérées de OpenChargeMap et seules les stations de recharge rapide à courant continu dont la puissance de charge est supérieure ou égale à 50 kW ont été prises en compte.

Les capacités potentielles ont été définies de 38kWh à 68 kWh, par pas de 5kWh.

Les portions de trajet sur autoroutes ont été considérées avec plusieurs vitesses de circulation possibles de 90km/h à 135 km/h par pas de 5km/h : dix vitesses de circulation ont donc été considérées pour cet exemple. Le graphe a été étendu pour chacune des portions de route concernées en multipliant chaque arc du graphe par dix.

L'efficacité de la propulsion électrique (le rendement) a été considérée à 85%.

Les conditions de trafic ont également été considérées à l'heure de pointe, à 8 heures du matin, d'un jour ouvrable (15 mars 2022) et ont été récupérées de HERE Maps.

Pour cet exemple, la température ambiante est supposée constante à 20°C, ce qui se traduit par une demande constante de puissance auxiliaire de 650W pour alimenter les auxiliaires du véhicule.

Les paramètres du modèle de temps de parcours ont été fixés à $T_d$=60 secondes et $T_s$=180 secondes.

La méthode de dimensionnement de l'invention a été utilisée pour deux stratégies :

- En optimisant la consommation énergétique par le planificateur d'itinéraires (on a alors λ=1);
- En optimisant le temps de parcours par le planificateur d'itinéraires (on a alors λ=0).

Ces stratégies ont été comparées à un comportement probable de l'utilisateur qui n'aurait pas accès à la méthode selon l'invention et qui commencerait à chercher la prochaine station de recharge rapide dès que l'état de la batterie tomberait en dessous de 40% et qui constitue l'art antérieur.

Avec la méthode de l'art antérieur (arrêt dès que possible lorsque l'état de charge de la batterie devient inférieur à 40%), l'utilisateur, qui n'accepterait que deux arrêts au cours du trajet, aurait besoin d'une batterie d'au moins 55 kWh installée dans le véhicule. Avec une batterie de 68 kWh, le trajet dure malgré tout près de 11 heures et la consommation d'énergie est d'environ 126kWh (à 91 km/h sur les portions d'autoroute). Avec une batterie de 55 KWh, le trajet dure environ 12 heures et la consommation énergétique est d'environ 126kWh (à 91km/h sur les portions d'autoroute).

Pour réduire la consommation d'énergie pour cette méthode de l'art antérieur, le paramètre principal est la vitesse de circulation sur les portions d'autoroute et ce indépendamment de la capacité de la batterie. En d'autres termes, cette méthode incite les usagers à investir dans des batteries de plus grande capacité et donc à augmenter les émissions de $CO_2$.

La première stratégie optimisée (optimisation de la consommation énergétique) de la méthode selon l'invention montre que le planificateur d'itinéraires peut améliorer à la fois le temps du trajet et la consommation d'énergie par rapport à la méthode de l'art antérieur. En effet, avec la méthode de l'invention et l'optimisation sur la consommation d'énergie, le trajet peut être réalisé en environ 11 heures (à une vitesse de circulation de 91 km/h sur les portions d'autoroute), avec une consommation d'environ 123 kWh et avec une batterie de 50 kWh. De plus, avec une batterie d'une capacité de 40kWh, le temps de trajet serait de 12 heures et la consommation d'environ 123 kWh (à une vitesse de circulation de 91 km/h sur les portions d'autoroute).

Ainsi, on peut, avec une capacité de batterie plus petite que celle de l'art antérieur, avoir un temps de trajet plus faible ou équivalent et ce en consommant moins d'énergie. La réduction de la capacité de la batterie (pour un même temps de trajet et une même vitesse de circulation sur autoroutes) est d'environ 25% par rapport à la méthode de l'art antérieur. Cela témoigne de la pertinence de la méthode selon l'invention.

La stratégie d'optimisation du temps de parcours de la méthode selon l'invention montre également que le planificateur d'itinéraires peut améliorer à la fois le temps du trajet et la consommation d'énergie par rapport à la méthode de l'art antérieur. Avec cette stratégie, le trajet peut être réalisé en environ 10,5 heures et avec une consommation énergétique de 124 kWh (à une vitesse de circulation de 91 km/h sur les portions d'autoroute) avec une batterie de capacité de 43kWh. Dans cette configuration, avec une capacité nette de batterie plus faible (43 kWh), quatre arrêts pour recharge seraient prévus le long du trajet. Avec une batterie de 40kWh, le trajet est réalisable en moins de 11 heures avec une consommation énergétique d'environ 125kWh en quatre arrêts également. Ainsi, avec cette stratégie, le temps de trajet et la consommation énergétique pourrait être réduits par rapport à la méthode de l'art antérieur tout en réduisant la taille de la batterie de plus de 40%.

**Revendications**

1. Méthode de dimensionnement d'une batterie d'un véhicule électrique pour implémenter la batterie dans ledit véhicule électrique, à partir de caractéristiques physiques dudit véhicule électrique, d'au moins un trajet d'une origine vers une destination dans un espace prédéterminé, des localisations de stations de recharge dans l'espace prédéterminé, de la puissance de chacune desdites stations de recharge, et d'un planificateur d'itinéraire, l'espace prédéterminé comprenant un réseau routier comprenant des portions de route (PR) reliées entre elles par des intersections, la méthode de dimensionnement comprenant au moins les étapes suivantes :

a) on définit plusieurs capacités potentielles (Capo) de la batterie, lesdites capacités potentielles étant comprises entre une première valeur et une deuxième valeur ;

b) pour chaque capacité potentielle de la batterie, on utilise le planificateur d'itinéraires (Plan) pour déterminer au moins un itinéraire possible dudit trajet, chaque itinéraire possible étant défini par une succession de portions de route, et on détermine le temps de parcours pour parcourir l'itinéraire possible par ledit véhicule électrique et/ou la consommation d'énergie par ledit véhicule électrique de chaque itinéraire possible ainsi que la position des stations de recharge à utiliser par le véhicule électrique sur chaque itinéraire possible pour recharger sa batterie et le niveau de recharge associé.

c) à partir des temps de parcours et consommation d'énergie déterminées pour chaque capacité potentielle de batterie et de la taille de chaque capacité potentielle de batterie, on identifie la capacité (Dim) de la batterie parmi lesdites capacités potentielles ;

et dans laquelle au moins l'étape b) est mise en oeuvre par ordinateur, et de préférence, toutes les étapes sont mises en oeuvre par ordinateur.

2. Méthode de dimensionnement selon la revendication 1, dans laquelle le planificateur d'itinéraires réalise au moins les étapes suivantes :

- on construit (Gr) un graphe de routage à partir du réseau routier, les sommets du graphe de routage représentant les intersections de chaque portion de route (PR) et les arcs du graphe de routage représentant les portions de route (PR),
- on positionne (Sp) les stations de recharge sur le graphe de routage,
- on étend (GrE) le graphe de routage en multipliant au moins certains arcs en fonction de paramètres prédéfinis, les paramètres prédéfinis comprenant la vitesse de circulation sur la portion de route considérée et/ou le niveau de recharge lors de l'arrêt à une station de recharge,
- on détermine (Conso) un modèle de consommation énergétique, le modèle énergétique définissant la consommation d'énergie du véhicule électrique en fonction de paramètres prédéterminés en prenant en compte les recharges éventuelles de la batterie du véhicule électrique,
- pour chaque trajet, on applique le modèle de consommation énergétique sur les différents arcs du graphe routage étendu et on définit comme itinéraire final du trajet possible, l'ensemble des arcs permettant de minimiser (Opt), par un algorithme d'optimisation tel qu'un algorithme du plus court chemin de Bellman-Ford, le temps de parcours, ou la consommation d'énergie ou un compromis défini comme un poids relatif entre ces deux paramètres,
- de préférence, on détermine (Pos_niv), à partir de l'itinéraire final défini, les positions des stations recharge utilisées par le véhicule électrique et le niveau de recharge réalisé à chaque station de recharge utilisée par le véhicule électrique pour le trajet considéré.

3. Méthode de dimensionnement la revendication 2, dans laquelle on considère plusieurs vitesses de circulation d'au moins une portion de route, chaque vitesse de circulation considérée étant comprise entre une première vitesse et une deuxième vitesse et on réitère l'étape b) pour chaque vitesse de circulation.

4. Méthode de dimensionnement selon l'une des revendications précédentes, dans laquelle les portions de route (PR) prennent en compte la topographie du réseau routier, notamment la pente de la portion de route, l'infrastructure et la signalisation au moyen d'un système d'information géographique, les données de trafic au moyen d'un système de géolocalisation ou d'un système d'information géographique et de préférence les données météorologiques au moyen d'un système d'interface de programmation d'application.

5. Méthode de dimensionnement selon l'une des revendications précédentes, dans laquelle on acquiert une mesure, sur chaque portion de route (PR) du réseau routier, du profil de vitesse (Pv) de plusieurs véhicules, au moyen d'un système de géolocalisation ou d'un téléphone embarqué pour déterminer, d'une part la vitesse moyenne des véhicules sur la portion de route, et d'autre part la probabilité d'arrêt des véhicules à la fin de la portion de route considérée, la probabilité d'arrêt étant déterminée par le pourcentage de véhicule pour lequel un arrêt est considéré à la fin de la portion de route, l'arrêt du véhicule étant considéré si, sur au moins un point de mesure de la deuxième moitié (P2) de la portion de route (PR), une vitesse du véhicule est inférieure à une valeur prédéfinie (C), la valeur prédéfinie étant de préférence inférieure ou égale à 10 km/h.

6. Méthode de dimensionnement selon l'une des revendications précédentes, dans laquelle les stations de recharge considérées par le planificateur d'itinéraires ont une puissance supérieure ou égale à 50kW.

7. Méthode de dimensionnement selon l'une des revendications précédentes, dans laquelle les caractéristiques physiques du véhicule électrique comprennent sa masse et sa consommation énergétique.

8. Méthode de dimensionnement selon l'une des revendications précédentes, dans laquelle à l'étape c), on identifie la capacité (Dim) de la batterie comme la capacité la plus petite parmi les capacités potentielles permettant un temps de trajet inférieur ou égal à une durée de trajet prédéterminée et/ou une consommation d'énergie inférieure ou égale à une consommation prédéterminée.

9. Méthode de construction d'un véhicule électrique, dans laquelle on identifie la capacité de la batterie à partir de la méthode de dimensionnement selon l'une des revendications 1 à 8, et on implante (Cons) ladite batterie de capacité identifiée dans le véhicule électrique.

10. Produit programme d'ordinateur téléchargeable depuis un réseau de communication et/ou enregistré sur un support lisible par ordinateur et/ou exécutable par un processeur ou un serveur, comprenant des instructions de code de programme pour la mise en oeuvre de la méthode de dimensionnement selon l'une des revendications 1 à 8, lorsque ledit programme est exécuté sur un ordinateur, un téléphone portable ou un appareil informatique.

**[Fig 1]**

[Fig 2]

Plan

```
┌─────────────┐
│     Gr      │
└─────────────┘
       │
       ▼
┌─────────────┐
│     Sp      │
└─────────────┘
       │
       ▼
┌─────────────┐
│     GrE     │
└─────────────┘
       │
       ▼
┌─────────────┐
│    Conso    │
└─────────────┘
       │
       ▼
┌─────────────┐
│     Opt     │
└─────────────┘
       │
       ▼
┌─────────────┐
│   Pos_niv   │
└─────────────┘
```

[Fig 3]

**EP 4 414 880 A1**

# RAPPORT DE RECHERCHE EUROPEENNE

Numéro de la demande

EP 24 15 5208

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | SHI XIAO ET AL: "Battery electric vehicles: What is the minimum range required?", ENERGY, ELSEVIER, AMSTERDAM, NL, vol. 166, 12 octobre 2018 (2018-10-12), pages 352-358, XP085565383, ISSN: 0360-5442, DOI: 10.1016/J.ENERGY.2018.10.056 * abrégé * * figures 2, 3, 6 * * page 353, section 2.1 * * page 354, colonne de gauche, liste de paramètres * * page 354, sections 2.2.1, 2.2.2 * * page 355, premier paragraphe * * le document en entier * | 1-10 | INV. G06F30/15 G01C21/26 G06Q10/047 G01C21/34 |

-----

-/--

**DOMAINES TECHNIQUES RECHERCHES (IPC)**

G06F
G06Q
G01C

Le présent rapport a été établi pour toutes les revendications

| Lieu de la recherche | Date d'achèvement de la recherche | Examinateur |
|---|---|---|
| Munich | 11 juin 2024 | Joris, Pierre |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

page 1 de 3

Europäisches
Patentamt

European
Patent Office

Office européen
des brevets

**RAPPORT DE RECHERCHE EUROPEENNE**

Numéro de la demande

EP 24 15 5208

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | MORLOCK FLORIAN ET AL: "Time Optimal Routing of Electric Vehicles Under Consideration of Available Charging Infrastructure and a Detailed Consumption Model", IEEE TRANSACTIONS ON INTELLIGENT TRANSPORTATION SYSTEMS, IEEE, PISCATAWAY, NJ, USA, vol. 21, no. 12, 29 octobre 2019 (2019-10-29), pages 5123-5135, XP011822802, ISSN: 1524-9050, DOI: 10.1109/TITS.2019.2949053 [extrait le 2020-11-25] * abrégé * * figures 1, 2, 6, 8 * * page 5125, première colonne, dernier paragraphe * * page 5125, sections A, B, C * * page 5126, deuxième colonne * * page 5127, deuxième colonne, premier paragraphe * * page 5129, deuxième colonne, troisième paragraphe * * page 5131, deuxième colonne, premier paragraphe * * page 5131, section B, deuxième paragraphe * * page 5128, section B * * page 5129, première colonne * * pages 5133-5134, section VII * * le document en entier * | 1-10 | |

-----

-/--

Le présent rapport a été établi pour toutes les revendications

| Lieu de la recherche | Date d'achèvement de la recherche | Examinateur |
|---|---|---|
| Munich | 11 juin 2024 | Joris, Pierre |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

Europäisches
Patentamt

European
Patent Office

Office européen
des brevets

## RAPPORT DE RECHERCHE EUROPEENNE

Numéro de la demande

EP 24 15 5208

### DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | THORGEIRSSON ADAM THOR ET AL: "An Investigation Into Key Influence Factors for the Everyday Usability of Electric Vehicles", IEEE OPEN JOURNAL OF VEHICULAR TECHNOLOGY, IEEE, vol. 1, 15 octobre 2020 (2020-10-15), pages 348-361, XP011818270, DOI: 10.1109/OJVT.2020.3031699 * abrégé * * figures 1, 9, 12-14 * * sections II.B-C, IV.A-D, V.B * * le document en entier * ----- | 1-10 | |
| Y | ZHOU YUE ET AL: "Optimal battery electric vehicles range: A study considering heterogeneous travel patterns, charging behaviors, and access to charging infrastructure", ENERGY, ELSEVIER, AMSTERDAM, NL, vol. 197, 25 janvier 2020 (2020-01-25), XP086100867, ISSN: 0360-5442, DOI: 10.1016/J.ENERGY.2020.116945 [extrait le 2020-01-25] * abrégé * * figure 5 * * sections 2.1, 2.3, 3.2, 3.3 * * le document en entier * ----- | 1-10 | DOMAINES TECHNIQUES RECHERCHES (IPC) |

Le présent rapport a été établi pour toutes les revendications

| Lieu de la recherche | Date d'achèvement de la recherche | Examinateur |
|---|---|---|
| Munich | 11 juin 2024 | Joris, Pierre |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

page 3 de 3

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3092181 A1

**Littérature non-brevet citée dans la description**

- **F. A. V. PINTO ; L. H. M. K. COSTA ; M. D. DE AMORIM.** Modeling Spare Capacity Reuse in EV Charging Stations based on the Li-ion Battery Profile. *International Conférence on Connected Vehicles and Expo (ICCVE),* 2014, 92-98

- **M. TREIBER ; A. HENNECKE ; D. HELBING.** Congested Traffic States in Empirical Observations and Microscopic Simulations. *Physical Review E,* 2000, vol. 62, 1805-1824